# NOUVEAU FASCICULE DE BREVET EUROPEEN

(11) **EP 1 904 901 B2**
(45) Date de publication et mention de la décision concernant l'opposition: **10.07.2013**
(45) Mention de la délivrance du brevet: 03.12.2008
(21) Numéro de dépôt: 06776066.0
(22) Date de dépôt: 21.06.2006
(51) Int. Cl.: G04B 1/00, C23C 14/10, C23C 14/06, C23C 14/02, C23C 16/40, C23C 16/34, C23C 16/32, C23C 16/02, C23C 16/27, C23C 16/26, C30B 33/00, C30B 29/06

(54) **PIECE DE MICRO-MECANIQUE RENFORCEE**
VERSTÄRKTES MIKROMECHANISCHES TEIL
REINFORCED MICROMECHANICAL PART

(30) Priorité: 28.06.2005 EP 05013912
(43) Date de publication de la demande: 02.04.2008
(73) Titulaire: ETA SA Manufacture Horlogère Suisse, 2540 Grenchen (CH)
(72) Inventeur: LIPPUNER, Marc, CH-2540 Grenchen (CH); PARATTE, Lionel, CH-2000 Neuchâtel (CH); CONUS, Thierry, CH-2543 Lengnau (CH); RAPPO, René, 2564 Bellmund (CH)
(74) Mandataire: Couillard, Yann Luc Raymond
(86) Numéro de dépôt international: PCT/EP2006/005959
(87) Numéro de publication internationale: WO 2007/000271

(56) Documents cités:
- EP-A- 0 732 635
- WO-A1-2004/092049
- DE-A1- 19 808 326
- DE-T2- 69 608 724
- FR-A- 2 855 651
- US-A- 4 196 233
- US-A- 5 424 224
- US-B2- 6 755 566
- KURT E. PETERSEN: 'Silicon as a Mechanical Material' PROCEEDINGS OF THE IEEE vol. 70, no. 5, 01 Mai 1982, pages 420 - 457, XP000565139
- K. YASUTAKE ET AL.: 'Crack healing and fracture strength of silicon crystals' JOURNAL OF MATERIALS SCIENCE 21 1986, pages 2185 - 2192
- BHUSHAN, B.: ' Tribology on the macroscale to nanoscale of microelectromechanical system materiales: a review' vol. 215, 2001,
- J. APPL. PHYS.: 'Materials Science Division' MICROMECHANICAL FRACTURE STRENGTH OF SILICON vol. 68, no. 11, 12 Juin 1990, pages 5840 - 5844

## Description

### DOMAINE TECHNIQUE

La présente invention concerne une pièce de micro-mécanique réalisée en silicium, et ayant subi un traitement lui conférant des propriétés mécaniques accrues. Il s'agit par exemple, mais de façon non limitative, d'une pièce de micro-mécanique d'un mouvement horloger mécanique c'est-à-dire soit d'une pièce ayant un rôle actif par exemple pour transmettre et/ou transformer une énergie afin d'entraîner des aiguilles pour donner une indication horaire sur un cadran, soit d'une pièce "passive" permettant par exemple de positionner des mobiles.

### ARRIERE PLAN TECHNOLOGIQUE

Le silicium est un matériau de plus en plus utilisé dans la fabrication de pièces mécaniques et notamment de pièces de micro-mécanique, qu'il s'agisse de pièces "captives", c'est-à-dire qui restent liées à un substrat sur lequel elles ont été usinées, ou de pièces "libres" telles que des pièces faisant partie de la chaîne cinématique d'un mouvement horloger.

Par rapport aux métaux ou alliages classiquement utilisés pour fabriquer des pièces de micro-mécaniques, telles que des roues dentées, des pièces articulées, ou des ressorts, le silicium présente l'avantage d'avoir une densité 3 à 4 fois plus faible et donc de présenter une inertie très réduite, et d'être insensible aux champs magnétiques. Ces avantages sont particulièrement intéressants dans le domaine horloger, tant en ce qui concerne l'isochronisme que la durée de marche lorsque la source d'énergie est constituée par un ressort.

Le silicium a toutefois, à juste titre, la réputation d'être sensible aux chocs, qui peuvent être nécessaires lors de l'assemblage, inévitables lors du fonctionnement, ou fortuits par exemple lorsque l'usager cogne, ou laisse tomber sa montre-bracelet.

Le document de brevet EP 1'422'436 A1 décrit un spiral en silicium formé d'un barreau en spirale revêtu sur toute sa surface d'une couche d'oxyde de silicium amorphe. Selon ce document, le premier coefficient thermique du module de Young pour l'oxyde de silicium amorphe est opposé à celui du silicium. Ainsi, la combinaison d'une âme en silicium avec une couche externe en oxyde permettrait de minimiser ledit premier coefficient thermique.

Ce document antérieur ne fait aucune allusion au problème que constitue la sensibilité aux chocs des pièces réalisées en silicium.

### RESUME DE L'INVENTION

La présente invention vise donc à apporter une solution visant à améliorer la résistance mécanique d'une pièce de micro-mécanique en silicium, et notamment sa résistance aux chocs.

A cet effet l'invention concerne une pièce de micro-mécanique en silicium selon la revendication indépendante 5.

L'invention concerne également un procédé de fabrication d'une pièce en silicium renforcé selon la revendication 1. Ce procédé permet de former, notamment par oxydation thermique, la couche amorphe épaisse qui augmente considérablement les propriétés mécaniques de ladite pièce, comme on le verra dans la description détaillée qui suit.

### BREVE DESCRIPTION DES DESSINS

D'autres caractéristiques et avantages de la présente invention apparaîtront plus clairement dans la description qui suit d'un exemple de réalisation, donné à titre illustratif et non limitatif, en référence aux dessins annexés dans lesquels:
- La figure 1 représente la section initiale d'un spiral en silicium
- la figures 2 correspond à la figure 1 après dépôt d'un matériau amorphe, et
- la figure 3 représente une étape supplémentaire de dépôt d'un revêtement anti-friction.

### DESCRIPTION DETAILLEE DE L'INVENTION

On a pris à titre d'exemple un spiral monté dans un mouvement horloger, et dont il est très facile de détecter le disfonctionnement, simplement en constatant l'arrêt du mouvement si ledit spiral vient à se briser, comme cela sera expliqué plus loin.

Le spiral est obtenu à partir d'une plaquette de silicium, ayant une épaisseur légèrement inférieure à la hauteur finale souhaitée pour le spiral, par les techniques connues de micro-usinage.

On peut par exemple faire appel à la technique de gravure ionique réactive (RIE) et donner au spiral la forme qu'on estime la plus appropriée, comme décrit par exemple dans la demande internationale WO2004/070476.

Compte-tenu des très petites dimensions d'un spiral, une même plaquette permet de fabriquer en une seule fois un lot de spiraux.

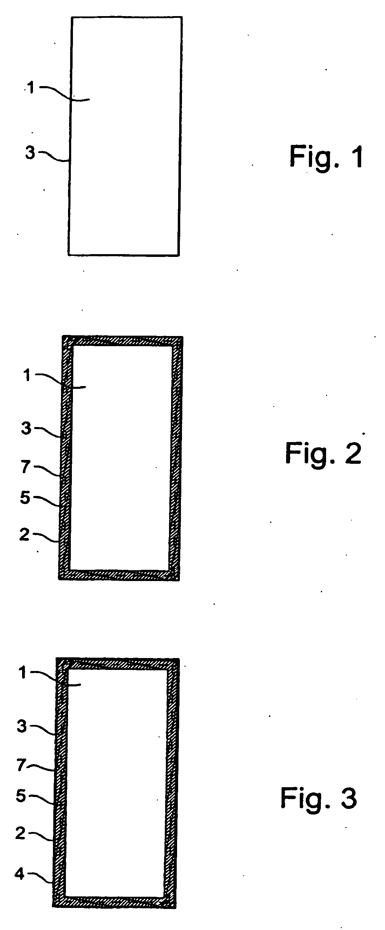

La figure 1 représente la section d'un spiral ayant une âme en silicium, la référence 3 désignant la surface extérieure initiale. Lorsque ce spiral est abandonné un certain temps au milieu ambiant, il se recouvre naturellement de dioxyde de silicium dit "oxyde natif" (non représenté) dont l'épaisseur est sensiblement comprise entre 1 et 10 nm.

La figure 2 représente la même section du spiral après traitement selon l'invention, par oxydation thermique surfacique entre 900°C et 1200°C. A cet effet on applique le protocole décrit dans l'ouvrage "Semiconductors devices : physics and technology (éds John Wiley & sons, ISBN 0-471-87424-8, 01.01 1985, p. 341-355). Ainsi, il faut environ 10h à une température de 1100°C pour obtenir une épaisseur de SiO₂ d'environ 1,9µm. Comme on le voit sur la figure 2, le dioxyde se forme au détriment du silicium dont le front 3 recule pour créer une nouvelle interface 5 avec le SiO₂ formé. Inversement, étant donné que SiO₂ a une densité plus faible, la surface extérieure 7 de SiO₂ s'étend au-delà de la surface initiale du spiral. Les positions de ces lignes de démarcation 3, 5 et 7 ne sont pas représentées à l'échelle, mais il est bien évident que la connaissance des propriétés physiques de Si et SiO₂ et des caractéristiques du traitement thermique permet de calculer les cotes initiales pour découper le spiral pour avoir en fin de ce traitement les cotes voulues.

Selon une première série d'essais, la résistance mécanique de pièces en silicium non oxydé et en silicium oxydé a été testée depuis le stade de fabrication jusqu'au montage.

Au cours de la fabrication d'un lot de pièces en silicium les pièces doivent être manipulées en différents stades de fabrication. Pour le cas précis décrit dans ce rapport il s'agit de pièces en silicium issues de deux plaquettes en silicium qui ont subi des opérations identiques.

Les pièces ont été ensuite montées dans un mouvement. Au cours des tests les pièces sont fixées sur un axe en acier et subissent des pincements aux brucelles ainsi qu'au posage de mesure. Au cours du montage final en mouvement, le centre de la pièce est chassé sur un axe massif.

Le tableau ci-après résume le résultat de cet essai effectué avec 19 pièces non oxydées et 36 pièces oxydées.

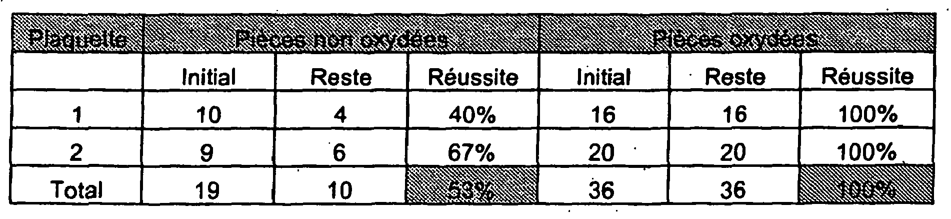

Lors de cet essai, la comparaison du taux de réussite de toute une chaîne d'opération montre bien que des pièces en silicium oxydées sont moins fragiles que les mêmes pièces sans oxydation.

Les propriétés mécaniques d'un spiral en silicium ordinaire (fig. 1) et d'un spiral modifié selon l'invention (fig.2) ont été également comparées en situation réelle après montage avec le test aux chocs au moyen d'un mouton pendule de 5000 g.

Deux mouvement identiques, dans lesquels ont été montés respectivement un spiral non traité et un spiral modifié selon l'invention ont été soumis à ce test de résistance mécanique.

Les mouvements équipés de spiraux non oxydés ou ayant un très faible dépôt d'oxyde natif se sont rapidement arrêté en raison de la rupture du spiral sous les chocs.

Les mouvements équipés de spiraux selon l'invention ont résisté pendant longtemps aux chocs et ont conservé une marche et un isochronisme tout à fait satisfaisants pendant plus de 30 semaines au porter.

Ainsi, de façon surprenante, en remplaçant un matériau, le silicium par un matériau de densité moindre, le dioxyde de silicium, on augmente la résistance mécanique, alors que logiquement on aurait pu s'attendre à une diminution de la résistance mécanique.

Dans l'exemple qui vient d'être décrit, la "couche épaisse amorphe" était du dioxyde de silicium. De façon équivalente on pourrait la former avec d'autres procédés de déposition, en utilisant d'autres matériaux tels que le nitrure ou le carbure de silicium, ou le carbure ou le nitrure de titane.

Cet exemple montre que toutes les surfaces extérieures de la pièce sont uniformément revêtues de dépôt amorphe épais. Il est bien évident qu'en utilisant des caches appropriés le dépôt pourrait être effectué sur seulement des parties choisies de la pièce, à savoir des parties plus particulièrement sollicitées sur le plan mécanique. Inversement, par exemple après un revêtement total en SiO₂, il est tout à fait possible d'éliminer certaines parties du revêtement par attaque chimique au BHF, par exemple pour des raisons esthétiques ou pour former un autre type de revêtement.

En se référant à la figure 3, on a représenté une variante dans laquelle une étape supplémentaire permet d'ajouter sur la couche épaisse amorphe 2 un revêtement 4 réalisé en un matériau choisi pour ses propriétés tribologiques.

La description précédente a été faite en prenant le spiral d'un mouvement horloger à titre d'exemple, mais il est bien évident que les mêmes avantages se retrouveraient pour toute autre pièce d'un mouvement horloger (roue dentée, roue d'échappement, ancre, pièces pivotées, etc...) et plus généralement toutes pièces d'un micro-mécanisme sans sortir du cadre de la présente invention.

## Revendications

1. Procédé de fabrication d'une pièce de micromécanique en silicium renforcé choisie parmi l'ensemble constitué des roues dentées, des roues d'échappement, des ancres, des pièces pivotées et des pièces passives, ledit procédé comportant, dans l'ordre, les étapes consistant à :
- micro-usiner la pièce, ou un lot de pièces dans une plaque de silicium
- effectuer, sur toute la surface de la pièce, en une ou plusieurs étapes, le dépôt de dioxyde de silicium, le dépôt étant effectué par oxydation thermique à une température comprise entre 900°C et 1200°C de la surface de la pièce pendant une durée suffisante pour obtenir une épaisseur de dioxyde de silicium au moins cinq fois supérieure à l'épaisseur d'un dioxyde de silicium natif.

2. Procédé selon la revendication 1, **caractérisé en ce que**, dans la première étape du procédé, la pièce est micro-usinée avec des cotes légèrement inférieures aux cotes finales souhaitées.

3. Procédé selon la revendication 1, **caractérisé en ce qu'**il comporte en outre une étape supplémentaire consistant à revêtir, au moins partiellement le dépôt de dioxyde de silicium d'un revêtement en un matériau choisi pour ses propriétés tribologiques, tel que le carbone cristallisé sous forme de diamant ou des nanotubes de carbone.

4. Procédé selon la revendication 1, **caractérisé en ce qu'**il comporte, après l'étape de dépôt d'un revêtement de dioxyde de silicium, l'étape d'éliminer certaines parties de ce revêtement par attaque chimique au BHF.

5. Pièce de micro-mécanique en silicium destinée à être intégrée dans un mécanisme horloger, **caractérisée en ce qu'**elle est susceptible d'être obtenue par le procédé selon l'une des revendications 1 à 4, ladite pièce étant choisie parmi l'ensemble constitué des roues dentées, des roues d'échappement, des ancres, des pièces pivotées et des pièces passives, **caractérisée en ce qu'**elle est revêtue sur toute sa surface de dioxyde de silicium et **en ce que** l'épaisseur formée est supérieure à cinq fois l'épaisseur du dioxyde de silicium natif.

6. Pièce selon la revendication 5, **caractérisée en ce que** le dépôt de dioxyde de silicium a une épaisseur supérieure à 50nm.

7. Pièce selon la revendication 5, **caractérisée en ce que** le dépôt de dioxyde de silicium est en outre au moins partiellement revêtu, pour ses parties en contact avec d'autres pièces d'une chaîne cinématique, d'un revêtement choisi pour ses propriétés tribologiques, tel que du carbone cristallisé sous forme de diamant (DLC) ou des nanotubes de carbone.

## Patentansprüche

1. Verfahren zum Herstellen eines verstärkten mikromechanischen Teils aus Silizium, ausgewählt aus der Gruppe der Zahnräder, Gangräder, Anker, Schwenkteile und passiven Teile, wobei das Verfahren der Reihe nach folgende Schritte umfasst:
- Mikroausarbeitung des Teils bzw. eines Loses von Teilen aus einer Siliziumplatte,
- Auftragen von Siliziumdioxid über die gesamte Oberfläche des Teils in einem oder mehreren Schritten, wobei die Auftragung durch thermische Oxidation bei einer Temperatur zwischen 900°C und 1200°C der Oberfläche des Teils für eine Zeitdauer erfolgt, die ausreicht, um eine Siliziumdioxiddicke zu erhalten, die zumindest das Fünffache der Dicke eines nativen Siliziumdioxids beträgt.

2. Verfahren nach Anspruch 1, **dadurch gekennzeichnet, dass** bei dem ersten Verfahrensschritt das Teil mit geringfügig kleineren Maßen als die gewünschten Endmaße mikrobearbeitet wird.

3. Verfahren nach Anspruch 1, **dadurch gekennzeichnet, dass** es ferner einen zusätzlichen Schritt umfasst, der darin besteht, zumindest teilweise den Siliziumdioxidauftrag mit einer Beschichtung aus einem aufgrund seiner tribologischen Eigenschaften ausgewählten Material zu beschichten, wie etwa kristallisierter Kohlenstoff in Form von Diamant oder Kohlenstoffnanoröhren.

4. Verfahren nach Anspruch 1, **dadurch gekennzeichnet, dass** es nach dem Schritt der Auftragung einer Siliziumdioxidbeschichtung den Schritt der Beseitigung bestimmter Abschnitte dieser Beschichtung durch Ätzen mit BHF aufweist.

5. Mikromechanisches Teil aus Silizium, das dazu bestimmt ist, in ein Uhrwerk eingebaut zu werden, **dadurch gekennzeichnet, dass** es mit dem Verfahren nach einem der Ansprüche 1 bis 4 erhalten werden kann, wobei das Teil ausgewählt ist aus der Gruppe der Zahnräder, Gangräder, Anker, Schwenkteile und passiven Teile, **dadurch gekennzeichnet, dass** es über die gesamte Oberfläche mit Siliziumdioxid beschichtet ist und dass die gebildete Dicke größer als das Fünffache der Dicke des nativen Siliziumdioxids ist.

6. Teil nach Anspruch 5, **dadurch gekennzeichnet, dass** der Siliziumdioxidauftrag eine Dicke von über 50 nm aufweist.

7. Teil nach Anspruch 5, **dadurch gekennzeichnet, dass** der Siliziumdioxidauftrag ferner im Bereich seiner Abschnitte, die weitere Teile einer kinematischen Kette kontaktieren, zumindest teilweise mit einer für ihre tribologischen Eigenschaften ausgewählten Beschichtung beschichtet ist, wie etwa kristallisierter Kohlenstoff in Form von Diamant (DLC) oder Kohlenstoffnanoröhren.

## Claims

1. Method for manufacturing a reinforced silicon micromechanical part, said part being selected from the group comprising toothed wheels, escapement wheels, pallets, pivoted parts, and passive parts, said method including, the successive steps consisting in:
- etching said part or a batch of said parts in a silicon plate,
- depositing over the entire surface of said part, in one or several steps, a silicon oxide layer, said deposition being made by thermal oxidation, at a temperature ranging from 900°C to 1200°C, of the surface of said part(s) for a sufficient period of time to obtain a silicon dioxide layer having a thickness which is at least five times greater than the thickness of native silicon dioxide.

2. Method according to claim 1, **characterized in that**, in the first step of the method, the part is etched with slightly smaller dimensions than the desired final dimensions.

3. Method according to claim 1, **characterized in that** it further comprises an additional step consisting in coating at least partially the silicon dioxide deposition with a coating of a material selected for its tribological properties, such as diamond like carbon or carbon nanotubes.

4. Method according to claim 1, **characterized in that**, after the step of depositing the silicon dioxide layer, it comprises a step of eliminating certain portions of said layer by chemical etching with BHF.

5. Silicon micromechanical part intended to be integrated in an horological mechanism, **characterized in that** it is obtained by the method according any of claims 1 to 4, **in that** said part is selected from the group comprising toothed wheels, escapement wheels, pallets, pivoted parts, and passive parts, **in that** said part is coated over its entire surface with silicon dioxide and **in that** the thickness of the said coating is five times greater than the thickness of the native silicon dioxide.

6. Part according to claim 5, **characterized in that** the silicon dioxide has a thickness greater than 50nm.

7. Part according to claim 5, **characterized in that** for the portions of silicon dioxide in contact with other parts of a kinematic chain, the silicon dioxide is also at least partially coated with a coating selected for its tribological properties, such as diamond like carbon (DLC) or carbon nanotubes.
